# EUROPEAN PATENT APPLICATION

(11) **EP 2 039 654 A2**
(43) Date of publication of application: **25.03.2009**
(21) Application number: 08163534.4
(22) Date of filing: 02.09.2008
(51) Int. Cl.: C01B 33/037, C01B 33/00

(54) **Washing method, Washing apparatus for polycrystalline silicon and method of producing polycrystalline**

(30) Priority: 04.09.2007 JP 2007229212; 27.06.2008 JP 2008168496
(71) Applicant: Mitsubishi Materials Corporation, Chiyoda-ku Tokyo (JP)
(72) Inventor: Sakai, Kazuhiro, Yokkaichi-shi, Mie-ken (JP)
(74) Representative: Cabinet Plasseraud

(57) **Abstract**

A washing method comprising: cleaning polycrystalline silicon with an acid solution; soaking of the polycrystalline silicon in a soaking bath in which pure water is stored; and measuring an electrical conductivity of the pure water in the soaking bath, wherein, in the soaking, the polycrystalline silicon is immersed in the pure water stored in the soaking bath, and the pure water in the soaking bath is replaced at least once to remove the acid solution remaining on a surface of the polycrystalline silicon; and in the measuring, completion of the soaking is determined based on measured values of the electrical conductivity

## Description

### BACKGROUND OF THE INVENTION

### Field of the Invention

The present invention relates to a washing method for polycrystalline silicon to be used, for example, as a raw material for semiconductor silicon, a washing apparatus for polycrystalline silicon which is suitable for carrying out this washing method, and a method of producing polycrystalline silicon using the washing method.

### Description of the Related Art

As a raw material of a single-crystal silicon wafer for semiconductor, for example, extremely high-purity polycrystalline silicon having a purity of 99.999999999% or higher is used. This polycrystalline silicon is produced by the so-called Siemens method in which trichlorosilane (SiHCl₃) gas and hydrogen gas are supplied into a reacting furnace in which silicon seed rods are placed, to deposit high-purity polycrystalline silicon on the silicon seed rods. Roughly columnar polycrystalline silicon ingots having a diameter of about 140 mm are obtained in this manner. Moreover, this polycrystalline silicon ingot is subjected to processing such as cutting and crushing or the like to give lumps of polycrystalline silicon. These lumps of polycrystalline silicon are classified by the size.

On the surface of the polycrystalline silicon ingot or the lump of polycrystalline silicon, contaminant adheres or an oxide film is formed. If the contaminants or oxide film get mixed in a production process, the quality of single-crystal silicon significantly decreases. Therefore, it needs to enhance cleanliness by washing polycrystalline silicon.

Thereupon, there has been proposed, for example, a washing method which includes a cleaning process with an acid solution and a subsequent soaking process with pure water as a method for washing the surface of polycrystalline silicon ingots and lumps of polycrystalline silicon in Japanese Unexamined Patent Application, First Publication Nos. 2000-302594 and 2002-293688.
As an acid solution to be used in the cleaning process, a mixed solution of hydrofluoric acid and nitric acid is used. Contaminants and an oxide film are removed by immersing polycrystalline silicon in the acid solution, thereby dissolving the surface of polycrystalline silicon. Thereafter, the polycrystalline silicon is washed with pure water to remove the acid solution remaining on the surface of polycrystalline silicon.

By the way, in the above-mentioned soaking process, it is required that the acid solution remaining on the surface of polycrystalline silicon is completely removed. A washing method such as spraying pure water cannot remove the acid solution got into asperity of the polycrystalline silicon surface. For this reason, it is necessary to immerse polycrystalline silicon for a long time in a soaking bath in which pure water is stored. Moreover, the pure water is gradually contaminated by the acid solution that has seeped into the pure water. Therefore, pure water is replaced at least one time to improve the cleanliness of polycrystalline silicon.

As a method for grasping a removal condition of the acid solution from the surface of polycrystalline silicon, a method for measuring the pH of pure water or the ion concentration is considered. However, in the measurement of pH or the ion concentration, analytical accuracy on the side of extremely low concentration, for example, a nitric acid concentration of 0.1 mg/L or less, is insufficient. Accordingly, there is a problem that grasping the removal condition of the acid solution with a high accuracy is impossible. In addition, since the measurement of ion concentration takes time, it is not easy to grasp the removal condition of the acid solution. Further, accurate measurement is difficult due to the effect of carbon dioxide in the air.

Therefore, it is an object of the present invention to provide a washing method and a washing apparatus, for polycrystalline silicon in which the removal state of the acid solution is grasped in high accuracy, and the completion of a soaking process is determined with ease and accuracy in a soaking process after cleaning, and a method of producing high quality polycrystalline silicon by washing.

### SUMMARY OF THE INVENTION

The present invention employs the followings in order to achieve the above-described object.
That is, a washing method includes: cleaning polycrystalline silicon with an acid solution; soaking of the polycrystalline silicon in a soaking bath in which pure water is stored; and measuring an electrical conductivity of the pure water in the soaking bath; wherein, in the soaking, the polycrystalline silicon is immersed in the pure water stored in the soaking bath, and the pure water in the soaking bath is replaced at least once to remove the acid solution remaining on a surface of the polycrystalline silicon; and in the measuring, completion of the soaking is determined based on measured values of the electrical conductivity.

According to the above-mentioned washing method of polycrystalline silicon, it becomes possible to remove an acid solution remaining on the surface of polycrystalline silicon effectively by replacing pure water in a soaking bath in which cleaned polycrystalline silicon was immersed, at least once with fresh pure water. Then, measuring an electrical conductivity of this pure water enables to estimate of the acid concentration in the pure water, grasp the removal state of the acid solution from the acid concentration, and determine the completion of a soaking process. Besides, the electrical conductivity can be measured in a short time. Even if the acid concentration is as extremely low as 0.1 mg/L or less, the electrical conductivity can be measured accurately.

It is also possible that the soaking is completed when the electrical conductivity becomes 2 µS/cm or less.
In this case, since soaking is completed when the electrical conductivity is 2 µS/cm or less, decrease of acid concentration in pure water can be accurately determined to an acid concentration unmeasurable in the conventional measurement of pH or ion concentration. Consequently, cleanliness of polycrystalline silicon can be surely improved.

The washing apparatus of the present invention includes: a soaking bath in which polycrystalline silicon cleaned with an acid solution is immersed, in pure water; a pure water discharge portion which exhausts the pure water from the soaking bath; a pure water supply portion which supplies fresh pure water to the soaking bath; and a measuring portion which measures an electrical conductivity of the pure water stored in the soaking bath.

According to the above-mentioned washing apparatus of polycrystalline silicon, since a soaking bath includes a pure water discharge portion and a pure water supply portion, pure water in the soaking bath in which polycrystalline silicon after cleaning had been immersed can be replaced with fresh pure water. Because of this, an acid solution remaining on the surface of polycrystalline silicon can be effectively removed. Furthermore, since the washing apparatus includes an electrical conductivity measuring portion, the removal state of the acid solution can be grasped by a change in the electrical conductivity of pure water, thereby determining the completion of a soaking process.

A method of producing polycrystalline silicon according to the invention includes: depositing polycrystalline silicon by the reaction of raw material gas containing chlorosilane gas and hydrogen gas; and washing the deposited polycrystalline silicon by the above-mentioned washing method for polycrystalline silicon.
According to the above-mentioned method of producing polycrystalline silicon, contaminants can be removed from the surface of the deposited polycrystalline silicon, and can also obtain high-quality polycrystalline silicon with no acid remaining used for the removal.

The present invention provides a washing method and a washing apparatus, which can determine completion of the removal of the acid solution with ease and accuracy in a soaking process after cleaning with an acid solution. Moreover, the deposited polycrystalline silicon is washed by the washing method to provide high quality polycrystalline silicon.

### BRIEF DESCRIPTION OF THE DRAWINGS

FIG. 1 is a flow chart showing a method of producing polycrystalline silicon which includes a washing method for polycrystalline silicon of an embodiment of the present invention.
FIG. 2 is a schematic diagram showing a washing apparatus for polycrystalline silicon of an embodiment of the present invention.
FIG. 3 is a graph showing a relationship between the electrical conductivity and the nitric acid concentration.
FIG. 4 is a schematic cross-sectional diagram showing a reacting furnace to be used in a silicon depositing process when producing polycrystalline silicon.
FIG. 5 is a front view showing lumps produced by crushing a rod of polycrystalline silicon taken out of the reacting furnace.

### DETAILED DESCRIPTION OF THE INVENTION

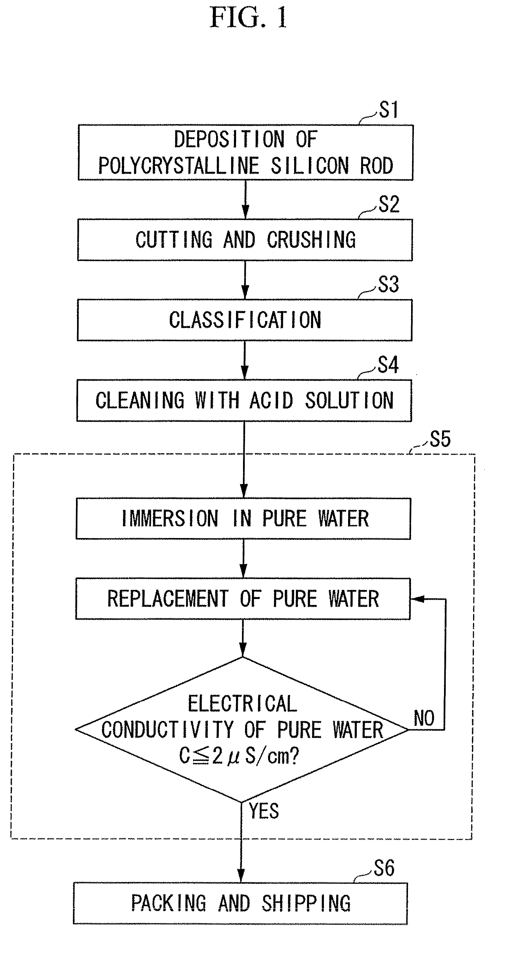

A washing method for polycrystalline silicon, a washing apparatus for polycrystalline silicone, and a method of producing polycrystalline silicon as embodiments of the present invention will now be described with reference to the drawings.
In the method of producing polycrystalline silicon according to a present embodiment, a polycrystalline silicon ingot is deposited by the so-called Siemens method, the ingot is cut and crushed, and the surfaces of the obtained lumps of polycrystalline silicon are washed. A flow chart of the method of producing polycrystalline silicon which includes the washing method of polycrystalline silicon as the present embodiment is indicated in FIG. 1.

### (Polycrystalline silicon depositing process S1)

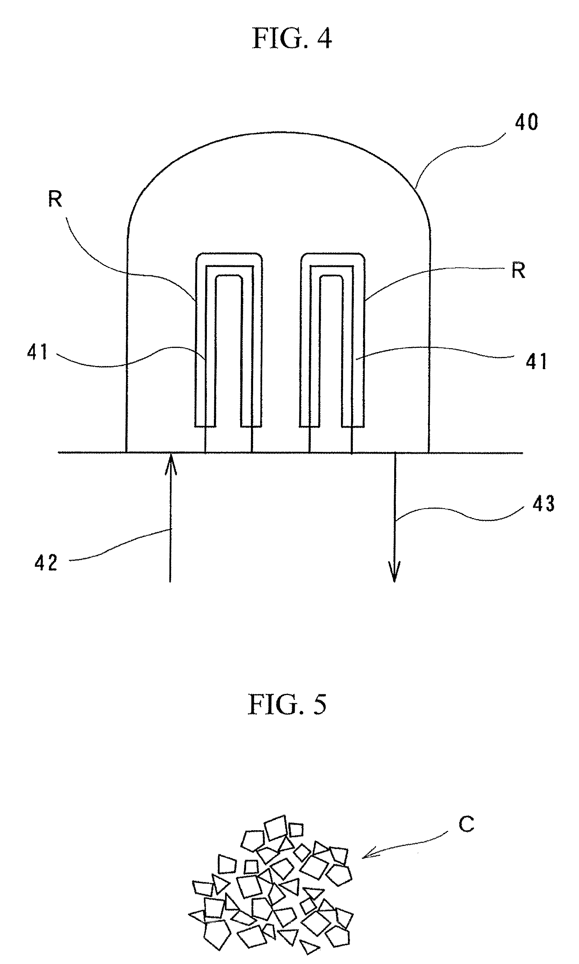

A polycrystalline silicon ingot is produced by the so-called Siemens method. In more detail, a plurality of silicon seed rods 21 is set up in a reacting furnace 20 as shown in FIG. 4. Into this reacting furnace 20, a raw material gas containing trichlorosilane gas and hydrogen gas is supplied from a raw material supply pipe 22. Then, trichlorosilane and hydrogen are reacted by applying electricity to the silicon seed rods 21, which deposits high-purity silicon on a surface of the silicon seed rods 21 as well as generating hydrochloric acid gas. By conducting this reaction, roughly columnar polycrystalline silicon ingots R which have a diameter of about 140 mm can be obtained. Gas in the reacting furnace 20 is discharged from a gas discharge pipe 23 to the outside.

### (Cutting and crushing process S2)

The thus obtained columnar ingot R is cut and crushed to be in a size chargeable into a crucible for producing single-crystal silicon. In the present embodiment, the ingot R is quenched after heating so as to allow cracking. After that, the ingot R is crushed with a hammer to obtain lumps of polycrystalline silicon S, called a lump as shown in FIG. 5.

### (Classification process S3)

According to the above-described cutting and crushing process, lumps of polycrystalline silicon of various sizes are formed. These lumps of polycrystalline silicon are classified by size.

In the cutting and crushing process and the classification process of a polycrystalline silicon ingot, contaminants such as dust adhere to or oxide films are generated on a surface of the lumps of polycrystalline silicon. With contaminants adhered to the surface of polycrystalline silicon or the oxide films generated thereon, they cannot be used as a raw material of single-crystal silicon. Therefore, polycrystalline silicon is washed as follows.

### (Cleaning process S4)

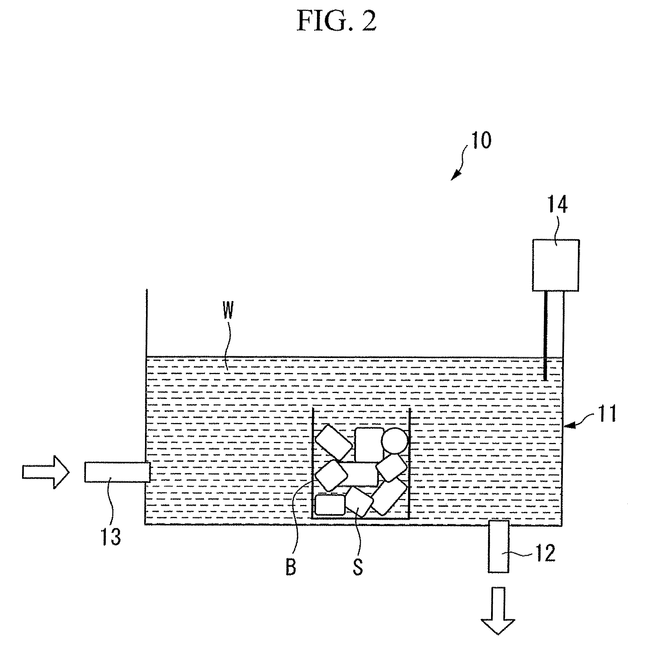

First of all, as shown in FIG. 2, polycrystalline silicon S which is contained in a basket B is immersed in a cleaning bath in which an acid solution is stored, and a cleaning process is carried out to dissolve and wash the surface of polycrystalline silicon S.
The acid solution contains nitric acids as a main component, and further contains small amount of hydrofluoric acid.

The polycrystalline silicon S is immersed in a plurality of cleaning baths in a state of being contained in the basket B, and moved up and down in the cleaning bath in the each basket B. As a result, the surface of polycrystalline silicon S is slightly dissolved, and contaminants and oxide films are removed.
Here, the basket B containing polycrystalline silicon S is composed of a synthetic resin, such as polyethylene, polypropylene, and polytetrafluoroethylene, which has corrosion resistance to the acid solution.

### (Soaking process S5)

After the above-mentioned cleaning process, soaking with pure water W is carried out to remove the acid solution.
In the soaking process, the polycrystalline silicon S kept in the basket B is immersed in a soaking bath 11 in which pure water W is stored. Here, the acid solution remaining on a surface of the basket B and the polycrystalline silicon S is washed away into the pure water W. The pure water W in the soaking bath I 1 is discharged outside, and fresh pure water W is supplied into the soaking bath 11. Pure water W is replaced at least once in this manner, and removal of the acid solution proceeds.
Moreover, it is preferable that the temperature of the pure water W in the soaking process is from 20°C to 25°C, and that the length of the soaking process is 20 hours or more.

The state of the removal of an acid solution from a polycrystalline silicon S is determined by measuring an electrical conductivity C of pure water W. In other words, in the state where the acid solution seeps into the pure water W, the acid concentration (nitric acid concentration) of pure water W is increased and accordingly the electrical conductivity C is increased. After the acid solution remaining on the surface of polycrystalline silicon S is sufficiently removed, the acid concentration (nitric acid concentration) of the pure water W is decreased, and accordingly the electrical conductivity C is also decreased. Therefore, by measuring the electrical conductivity C, the removal state of acid solution from polycrystalline silicon S can be grasped. In the present embodiment, it is determined that the removal of acid solution is complete when the electrical conductivity C is 2 µS/cm or less. A specific resistance of pure water which is supplied to the soaking bath 11 is desirably ultrapure water of 15 MΩ·cm or more.

### (Packing and shipping process S6)

Thus polycrystalline silicon S in which the acid solution is removed in the soaking process is packed and shipped after drying.
Then, the polycrystalline silicon S is filled in a crucible for producing single-crystal silicon as a raw material of single-crystal silicon, and melted.

Next, a washing apparatus for polycrystalline silicon 10 as an embodiment of the invention will be described. As shown in FIC.2, this washing apparatus 10 is composed by a soaking bath 11 in which pure water W is stored, a pure water discharge portion 12 to discharge the pure water W which is stored in the soaking bath 11 to the outside; and a pure water supply portion 13 to supply fresh pure water W to the soaking bath 11. In the present embodiment, the pure water discharge portion 12 is composed so as to discharge pure water W from the bottom of the soaking bath 11 to the outside.

Polycrystalline silicon S after cleaning is immersed in a soaking bath 11 in a state of being kept in a basket B. Pure water W in the soaking bath 11 is discharged to the outside by the pure water discharge portion 12. Thereafter, fresh pure water W is supplied into the soaking bath 11 by the pure water supply portion 13, and the polycrystalline silicon S is again immersed in pure water W. Pure water W is replaced at least once in this manner to soak the polycrystalline silicon S.
One cycle of replacement includes immersing polycrystalline silicon S which is a washing object in the soaking bath 11 for a predetermined time, discharging pure water W in the soaking bath 11 from the pure water discharge portion 12, and then supplying fresh pure water W of the amount corresponding to the soaking bath 11 by the pure water supply portion 13.

In the washing apparatus for polycrystalline silicone 10, an electrical conductivity measuring portion 14 which measures the electrical conductivity C of pure water W stored in the soaking bath 11 is equipped. The electrical conductivity C in pure water W is continuously measured by this electrical conductivity measuring portion 14. When the electrical conductivity C becomes 2 µS/cm or less, the soaking process is terminated.

As described above, in the washing method for polycrystalline silicon of the present embodiment, polycrystalline silicon S in the basket B after cleaning is immersed in pure water W in a state of being kept in the soaking bath 11. Furthermore, by replacing pure water W in the soaking bath 11 at least once, the acid solution remaining on the surface of polycrystalline silicon S is removed, and then the electrical conductivity C of the pure water W in the soaking bath 11 is measured. Due to this, completion of the soaking process can be determined by estimating the acid concentration (nitric acid concentration) of the pure water W, thereby grasping the removal state of the acid solution. In addition, the electrical conductivity C can be measured in a short period of time, and also can be measured accurately even if the acid concentration (nitric acid concentration) is extremely low. Consequently, the completion of the soaking process can be determined with ease and accuracy as for polycrystalline silicon S which requires high cleanliness.

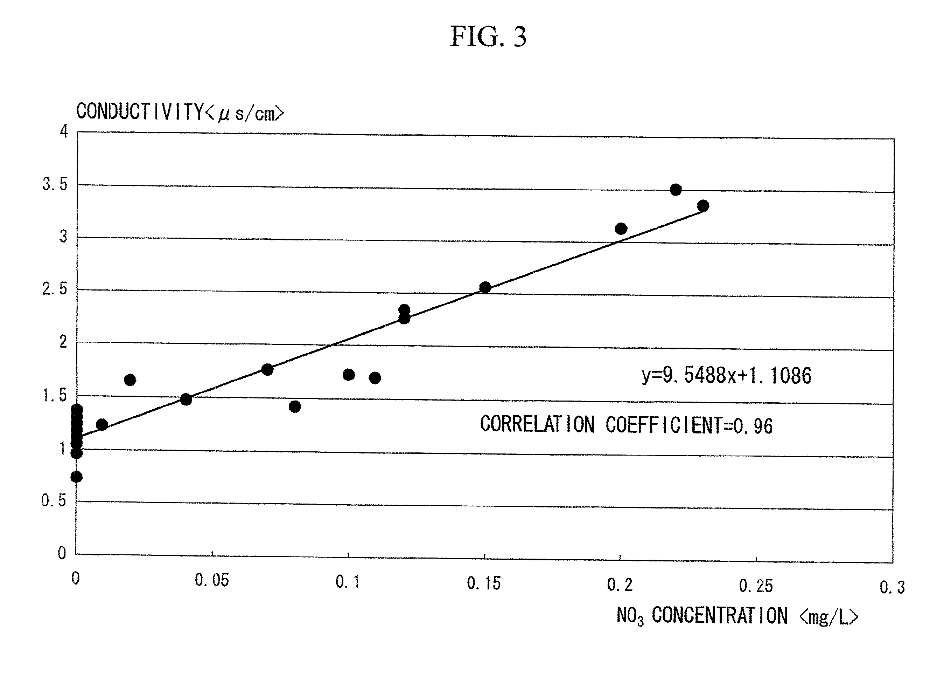

In the present embodiment, when the electrical conductivity C of pure water W becomes 2 µS/cm or less, it is determined that the removal of the acid solution of polycrystalline silicon S is complete, and thus the soaking is terminated. As a result, the soaking is terminated in a very low acid concentration so that the electrical conductivity C is 2 µS/cm or less, and the cleanliness of polycrystalline silicon S can be reliably improved. Here, the relationship between the electrical conductivity C and the nitric acid concentration is shown in FIG. 3. When the electrical conductivity C is 2 µS/cm or less, the nitric acid concentration becomes very low to less than 0.1 mg/L which is impossible to be measured according to a pH measurement or an ion concentration measurement. Specifically, since the soaking process can be terminated with the acid solution fully removed, polycrystalline silicon with a high level of cleanliness can be obtained.

In the washing apparatus for polycrystalline silicon 10 of the present, in soaking bath 11, a pure water discharge portion 12 and a pure water supply portion 13 are included. Due to this, pure water W in the soaking bath 11 in which polycrystalline silicon S is immersed can be discharged, fresh pure water W can be supplied, and the pure water W can be replaced at least one time or more. As a result, the acid solution remaining on the surface of polycrystalline silicon S can be effectively removed. Further, since the washing apparatus has an electrical conductivity measuring portion 14, the removal state of the acid solution can be grasped by the change of the electrical conductivity C of pure water W.

In the washing apparatus for polycrystalline silicon 10 of the present embodiment, the pure water discharge portion 12 is constituted in the manner to allow discharging pure water W from the bottom of the soaking bath 11. This can prevent impurity particles or the like which seeps into pure water W from remaining in the soaking bath 11, and improve the cleanliness of polycrystalline silicon S.

In the present embodiment, the cleaning process and the soaking process are carried out in the state of polycrystalline silicon S being kept in the basket B which is composed of synthetic resin such as polyethylene, polypropylene, and polytetrafluoroethylene having corrosion resistance to an acid solution. Thus polycrystalline silicon S can be washed efficiently and certainly.

As above, embodiments of the present invention are illustrated, but the invention is not limited thereto, and can be suitably changed without departing from the technical idea of the invention.
For example, a soaking process is complete when the electrical conductivity C is 2 µS/cm or less, but it is not limited to this. That is, it is preferable to appropriately set the electrical conductivity depending on the desired cleanliness for polycrystalline silicon. However, if the electrical conductivity C is set to 2 µS/cm or less, the nitric acid concentration becomes less than 0.1 mg/L. As a result, an acid solution can be reliably removed.

With regard to the washing apparatus for polycrystalline silicon of the present embodiment, a constitution that allows discharge of pure water from the bottom of the soaking bath by a pure water discharge portion is illustrated. However, it is not limited to this. That is, it is only necessary to discharge pure water from the soaking bath to the outside.
In addition, lumps of polycrystalline silicon are washed, but the form of polycrystalline silicon is not limited. That is, for example, a columnar polycrystalline silicon ingot may be washed. In this case, the polycrystalline silicon may be employed as a raw material for a solar cell, in addition to a raw material for single-crystal silicon.
While preferred embodiments of the invention have been described and illustrated above, it should be understood that these are exemplary of the invention and are not to be considered as limiting. Additions, omissions, substitutions, and other modifications can be made without departing from the spirit or scope of the present invention. Accordingly, the invention is not to be considered as being limited by the foregoing description, and is only limited by the scope of the appended claims.

## Claims

1. A washing method comprising:
cleaning polycrystalline silicon with an acid solution;
soaking of the polycrystalline silicon in a soaking bath in which pure water is stored; and
measuring an electrical conductivity of the pure water in the soaking bath,
wherein, in the soaking, the polycrystalline silicon is immersed in the pure water stored in the soaking bath, and the pure water in the soaking bath is replaced at least once to remove the acid solution remaining on a surface of the polycrystalline silicon; and
in the measuring, completion of the soaking is determined based on measured values of the electrical conductivity.

2. The washing method for polycrystalline silicon according to claim 1, wherein
the soaking is completed when the electrical conductivity becomes 2 µS/cm or less.

3. A washing apparatus for polycrystalline silicon, comprising:
a soaking bath in which polycrystalline silicon cleaned with an acid solution is immersed, in pure water;
a pure water discharge portion which exhausts the pure water from the soaking bath;
a pure water supply portion which supplies fresh pure water to the soaking bath; and
a measuring portion which measures an electrical conductivity of the pure water stored in the soaking bath.

4. A method of producing polycrystalline silicon comprising:
depositing polycrystalline silicon by the reaction of raw material gas containing chlorosilane gas and hydrogen gas; and
washing the deposited polycrystalline silicon by the washing method for polycrystalline silicon according to claim 1 or 2.
